# EUROPEAN PATENT APPLICATION

(11) **EP 4 756 473 A1**
(43) Date of publication of application: **10.06.2026**
(21) Application number: 24217006.6
(22) Date of filing: 03.12.2024
(51) Int. Cl.: G01R 33/563

(54) **GENERATING MR IMAGES OF THE HEART OF A PATIENT**

(71) Applicant: Siemens Healthineers AG, 91301 Forchheim (DE); King's College London, London WC2R 2LS (GB)
(72) Inventor: Kunze, Karl-Philipp, London, SW10 9JR (GB); Neji, Radhouene, London, N65XP (GB)
(74) Representative: Siemens Healthineers Patent Attorneys

(57) **Abstract**

The invention relates to a method for generating MR images of a heart of a patient, with selecting first 3D MR datasets acquired at a first breath hold of the patient over a plurality of cardiac phases and selecting second 3D MR datasets acquired at a second breath hold of the patient over several cardiac phases. A first combined MR dataset is generated based on at least some of the first 3D MR datasets at the first breath hold, and a second combined MR dataset is generated based on at least some of the second 3D MR datasets at the second breath hold. A motion information for the heart between the first and second breath hold is determined based on the first and second combined MR dataset. For each of the plurality of cardiac phases, MR images of the heart are reconstructed based on the first 3D MR datasets, the motion information and the second 3D MR datasets.

## Description

### TECHNICAL FIELD

The present application relates to generating MR images of the heart providing a dynamic visualisation of cardiac motion. The application especially relates to a method for operating a processing unit for generating MR images, to an MR imaging system and to a computer program.

### BACKGROUND

When recording MR images of moving organs, the organ's own movement, for example the heart, must be taken into account and possibly the movement of the entire organ due to the movement of the environment. This is the case with the movement of the heart or liver during respiration. A first possibility for imaging moving objects is the so-called single-shot technique, in which the raw data space, also called k-space hereinafter, is read out completely after an RF pulse is emitted and in which the recording of the data is fast enough to freeze the movement. Another recording option is the segmented recording technique, in which the data recording for an image is divided into several movement cycles and MR data is only recorded in comparable movement phases. In cardiac imaging, respiration and cardiac movement must be taken into account. Movement due to breathing can be minimized by breath-holding techniques or frozen by navigator gating. The first option limits the measurement time, and the second option limits the efficiency and increases the complexity.

One option for heart imaging is based on CINE imaging providing a kind of movie of the beating heart. CINE imaging is important for the diagnosis of cardiac function. Accordingly, multiplanar CINE studies are an important component of nearly every cardiac MR examination and provides dynamic visualization of cardiac motion states at high temporal resolution, which is the basis for calculation of important clinical parameters such as (Left-) ventricular Ejection Fraction (EF). A fundamental drawback of established techniques is that they acquire the heart slice-by-slice in prospectively planned views, leading to ~20 breath holds in a standard CMR exam for whole-heart coverage and significant operator input at scan time. Achieving a fully isotropic 3D cine CMR exam in a more efficient way is therefore highly desirable for improving patient comfort and reducing scan time, and additionally avoiding the need for prospective slice planning as 3D data can be reformatted retrospectively.

A number of techniques exist for the acceleration of 2D data acquisitions using e.g. compressed sensing and effort has been undertaken to achieve free-breathing 2D cine imaging, but the problem of prospective slice planning remains. For 3D cine, research efforts have been made to either 1) achieve single-breath hold acquisitions, which are challenged by the extremely high under-sampling and long breath hold duration, or 2) completely free-running acquisitions, which avoid the need for breath holding and potentially ECG gating, but add additional scan time and post-processing complexity as data has to be gated and reconstructed both in respiratory and cardiac motion dimensions. Long breath hold durations are often only possible for a very small number of patients.

Accordingly a need exists to overcome the drawbacks above and to improve the possibility for imaging of the beating heart also for patients which can not support ling breath hold durations.

### SUMMARY

According to a first aspect a method for generating MR images of a heart of the patient is provided wherein a processing unit carries out the steps of selecting first 3D MR datasets acquired at a first breath hold of the patient over a plurality of cardiac phases. Furthermore, second 3D MR datasets acquired at a second breath hold of the patient over several cardiac phases are selected and a first combined MR dataset is generated based on at least some of the first 3D MR datasets at the first breath hold and a second combined MR dataset is generated based on at least some of the second 3D MR datasets at the second breath hold. Motion information is then determined for the heart between the first and second breath holds based on the first and second combined MR datasets. For each of the plurality of cardiac phases MR images of the heart are reconstructed based on the first 3D MR datasets, the motion information and the second 3D MR datasets.

Accordingly, a number of breath holds (2 or more) is used and the motion of the heart between the breath hold positions is considered as motion information. With this motion information representing the respiratory motion information between the breath holds it is possible to reconstruct 3D MR images.

The MR images can be generated based on images obtained during two or more breath holds such as two or four breath holds.

Preferably the 3D MR datasets are k-space datasets and each of the first and second 3D MR datasets comprises a central part and a peripheral part with the central part comprising a higher k-space density than the peripheral part.

Here it is possible that the 3D MR datasets, the first and the second 3D MR dataset were acquired with several receiving coils and a 3D coil sensitivity map is determined from a central part of the first combined MR dataset or from the central part of the second combined MR dataset and the 3D coil sensitivity map is used for determining the final 3D MR datasets.

Preferably the first and the second 3D MR datasets are configured such that they have substantially no inner k-space data point in common. In other words, the sampling positions are varied in a CAIPIRINHA-like fashion between the different breath holds. In the same way it is preferred that a first 3D MR dataset acquired at a first cardiac phase and another first 3D MR dataset acquired at the same breath hold at another cardiac phase are acquired such that they do not have k-space data points in common.

Preferably, the method can include the steps of determining a motion compensated second 3 D MR dataset for each of the cardiac phases based on the motion information and the second 3D MR dataset, and the step of reconstructing the MR images comprises combining the first 3D MR dataset of a first cardiac phase with the motion compensated second 3D MR dataset of the first cardiac phase, and combining the first 3D MR dataset of a second cardiac phase with the motion compensated second 3D MR dataset of the second cardiac phase, wherein the MR images are cardiac phase specific datasets.

Determining the motion information can include the steps of determining a first breath hold image based on a subset of the first 3D MR datasets and the 3D coil sensitivity map, determining a second breath hold image based on a subset of the second 3D MR datasets and the 3D coil sensitivity map, and determining the motion information based on a comparison of the first breath hold image to the second breath hold image. The first breath hold image and the second breath hold image should contain as little cardiac motion as possible. One option to achieve this includes the using a minimum number of the first 3D MR datasets and a minimum number of the second 3D MR datasets, wherein the minimum number is a subset of the MR datasets. The subset of the first and second 3D MR image datasets could be determined based on a number of breath hold acquisitions and an acceleration factor used in a central part of the corresponding 3D MR image datasets. The subset of the first and second 3D MR image datasets could be determined such that a cardiac motion in the first and second breath hold images is minimized. More precisely, it is possible that a number of first 3D MR datasets contained in the subset is the minimum number of datasets from the first 3D MR datasets obtained based on an acceleration factor used in a central part of each of the first 3D MR datasets times a number of breath holds, wherein this minimum number of datasets, when combined, provides a fully sampled central part in k space.

The determination of the final 3D MR datasets can comprise the step of combining the first 3D MR dataset of a first cardiac phase with the motion compensated second 3D MR dataset of the first cardiac phase and combining the first 3D MR dataset of a second cardiac phase with the motion compensated second 3D MR dataset of the second cardiac phase resulting in cardiac phase specific 3D MR datasets for the final dataset. Accordingly, for the different cardiac phases phase-specific MR datasets are combined over the different breath holds, but for the same cardiac phase.

The selected first 3D MR datasets and the second 3D MR datasets can be acquired such that the first and the second MR datasets have the same number of k-space data points.

Preferably the first 3D MR datasets were acquired such that the central part of the first combined 3D dataset is a fully sampled k-space and the second 3D MR datasets were acquired such that the central part of the second combined 3D dataset is a fully sampled k-space in the combined 3D dataset. A fully sampled k-space first of all helps to precisely determine the motion information with the use of a 3D coil sensitivity map which can be determined from the central part of the first combined MR dataset.

The MR images can be generated using compressed sensing technique.

The first 3D MR dataset can be acquired at a first cardiac phase and the second 3D MR dataset acquired at the same first cardiac phase can be combined to the phase specific MR dataset and the central part of this phase-specific MR dataset is a fully sampled k-space dataset whereas the peripheral part is not a fully sampled k-space part. The peripheral part may have an elliptical outer shape in a direction perpendicular to the read out direction wherein the central part can have a rectangular shape.

In the example above 2 breath holds were used, but it should be understood that N breath holds, with N>= 2, could be used. Here N 3D MR datasets are selected at N breath holds, wherein the motion information is determined N-1 times. One of the 3D MR datasets place the role of a reference dataset, it can be the dataset obtained at the first breath hold, but it can be any of the datasets. In the discussion above and below, the expression "first datasets" does not necessarily mean that it was acquired earlier in time than the second datasets or that the first breath hold was earlier in time than the second breath hold. It could mean that the datasets at the first breath hold play the role of the reference dataset and the motion information is determined for the other breath holds relative to this breath hold.

Furthermore, the corresponding processing unit configured to generate the MR images of the heart is provided configured to operate as discussed above or as discussed in further detail below. Furthermore, a computer program comprising program code is provided which when executed by the processing unit causes the processing unit to perform a method as discussed above or as discussed in further detail below.

Last but not least a carrier comprising the computer program is provided wherein the carrier is one of an electronic signal, optical signal, radio signal, and computer-readable storage medium.

### BRIEF DESCRIPTION OF THE DRAWINGS

The foregoing and additional features and effects of the application will become apparent from the following detailed description, when read in conjunction with the accompanying drawings in which like reference numerals refer to like elements.
Fig. 1 shows a schematic view of an MR imaging system with which images can be generated at different breath holds and which can generate a movie like sequence of MR images of the heart.
Fig. 2 shows a schematic view of MR datasets used to generate the movie like sequence of MR images.
Fig. 3 shows a schematic view of a processing workflow used to generate the movie like sequence of MR images.
Fig. 4 is a schematic view of a flowchart carried out at a processing unit for generating MR images for different positions through the heart showing the movement of the heart.

### DETAILED DESCRIPTION OF THE DRAWINGS

In the following, embodiments of the invention will be described in detail with reference to the accompanying drawings. It is to be understood that the following description of embodiments is not to be taken in a limiting sense. The scope of the invention is not intended to be limited by the embodiments described hereinafter or by the drawings, which are to be illustrative only.

The drawings are to be regarded as being schematic representations, and elements illustrated in the drawings are not necessarily shown to scale. Rather, the various elements are represented such that their function and general purpose becomes apparent to a person skilled in the art. Any connection or coupling between functional blocks, devices, components of physical or functional units shown in the drawings and described hereinafter may be implemented by an indirect connection or coupling. A coupling between components may be established over a wired or wireless connection. Functional blocks may be implemented in hardware, software, firmware, or a combination thereof. Independent of the grammatical term usage, individuals with male, female or other gender identities are included within the term.

In the following a solution is discussed providing a compromise between the single breath hold and free-running approaches, by introducing an accelerated imaging framework that uses a 3D image dataset (e.g. a CINE image data set) in a small number (2 - 4) of breath holds, while efficiently handling potential motion between breath hold positions using a motion-compensated reconstruction. The resulting 3D+time dataset is a succession of typically several, such as around 20 3D volumes, each representing one cardiac phase, i.e. one contractile state of the myocardium.

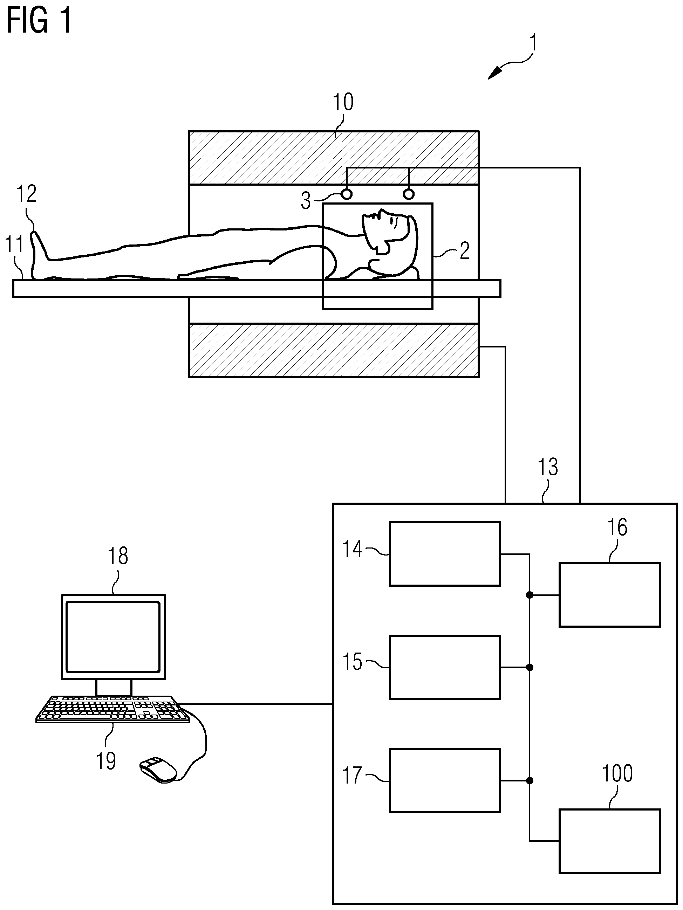

Figure 1 shows a schematic view of an MR system 1 which can acquires 3D MR image datasets which can be used to generate CINE images of the heart in different slice positions. The MR system 1 compromises a magnet 10 generating a polarization field B0. An object under examination or patient 12 lying on a table 11 is moved into the center of the MR system 1 where MR signals after RF excitation can be detected by receiving coils 2 which can comprise different coil sections wherein each coil section is associated with a corresponding detection channel 3. By applying RF pulses and magnetic field gradients, the nuclear spins in the patient 12 and especially in the part located in the receiving coil 2, here the heart, are exited and location coded and the currents induced by the relaxation can be detected. The way how MR images are generated and how the MR signals are detected using a sequence of RF pulses and the sequence of magnetic field gradients are known in the art so that a detailed explanation thereof is omitted.

The MR system comprises a control module 13 which is used for controlling the MR system. The control module 13 comprises a gradient control unit 14 for controlling and switching the magnetic field gradients, an RF control unit 15 for controlling and generating the RF pulses for the imaging sequences. An image sequence control unit 16 is provided which controls the sequence of the applied RF pulses and magnetic field gradients and thus controls the gradient control unit 14 and the RF control unit 15. In a memory 17, computer programs needed for operating the MR system and the imaging sequences necessary for generating the MR images can be stored together with the generated MR images. The generated MR images can be displayed on a display 18 wherein an input unit 19 is provided used by a user of the MR system to control the functioning of the MR system. A processing unit 100 can coordinate the operation of the different functional units shown in Figure 1 and can comprise one or more processors which can carry out instructions stored on the memory 17. The memory includes the program code to be executed by the processing unit 100. The processing unit can, based on the detected images reconstruct an MR images. The processing unit 100 can furthermore calculate and generate CINE MR images of the heart as will be explained in more detail below.

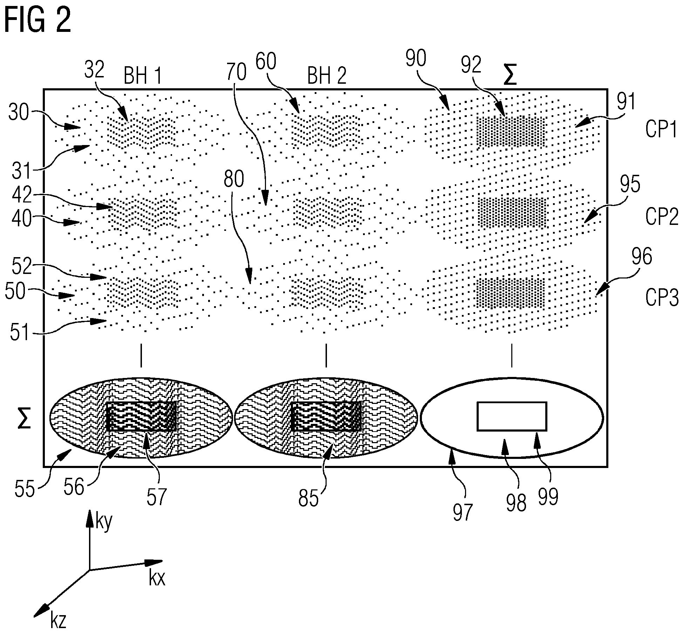

In the following a solution is discussed which can be seen as a solution located between a single breath hold and the free-running approaches described in the introductory part. An accelerated imaging framework is provided that acquires a 3D CINE data set in a small number of breath holds such as two to four breath holds while efficiently handling potential motion between breath hold positions using a motion compensated reconstruction. The resulting 3D plus time dataset is a succession of several 3D volumes such as between 10 and 25 volumes, each representing one cardiac phase meaning one contractile state of the myocardium. To support the motion compensated 3D and time reconstruction with the necessary respiratory motion information, it is helpful to first reconstruct an intermediate 3D image ( a breath hold image called hereinafter) representing the exact respiratory position of each breath hold in 3D the image acquisition and reconstruction is discussed in further detail in connection with Fig. 2. In the following, MR datasets are considered to be k space datasets, whereas MR images relate to the image space and not to the k-space.

Fig. 2 shows a schematic k-space view of the three-dimensional image acquisition wherein each shown in Fig. 2 shows a data acquisition of the MR signal in a plane perpendicular to the image plane, in the embodiment shown the k_{z} direction. As shown in Fig. 2 during a first breath hold (BH1) the datasets 30, 40, and 50 are acquired at different cardiac phases CP1 to CP 3. As indicated above, 10 to 25 image datasets may be acquired at each breath hold. Each of these three-dimensional datasets 30-50 comprise a central part 32, 42, 52 and a peripheral part 31, 41 or 51. The central parts 32, 42, 52 have a higher sampling density than the peripheral parts 31, 41, 51. In the embodiment shown the central part 32 has a rectangular shape whereas the surrounding part has an ellipsoidal shape. During the same breath hold the data set 40 is acquired again with the central part 42 and the peripheral part 41. In the same way and in the same breath hold the dataset 50 is acquired. It should be noted that the data sets 30 or 40 and 50 were acquired such that preferably they do not have k-space points in common. As an imaging sequence the following imaging sequences can be used. A Spoiled gradient echo sequence or bSSFP (balanced steady state free precession) readout can be used. Spin-echo techniques could also be employed if fast enough. The invention can be employed using both prospectively gated acquisition as well as retro-gated CINE acquisitions. The k-space data sets acquired at the first breath hold are acquired at different cardiac phases as symbolized by CP1, CP2 and CP3. The image acquisition can be repeated at a second breath hold, BH2 with datasets 60, 70 and 80. In the embodiment shown an acquisition with two breath holds was used, however it should be understood that any other number of breath holds between 2 and N, N being the range between 2 and 6, could be used.

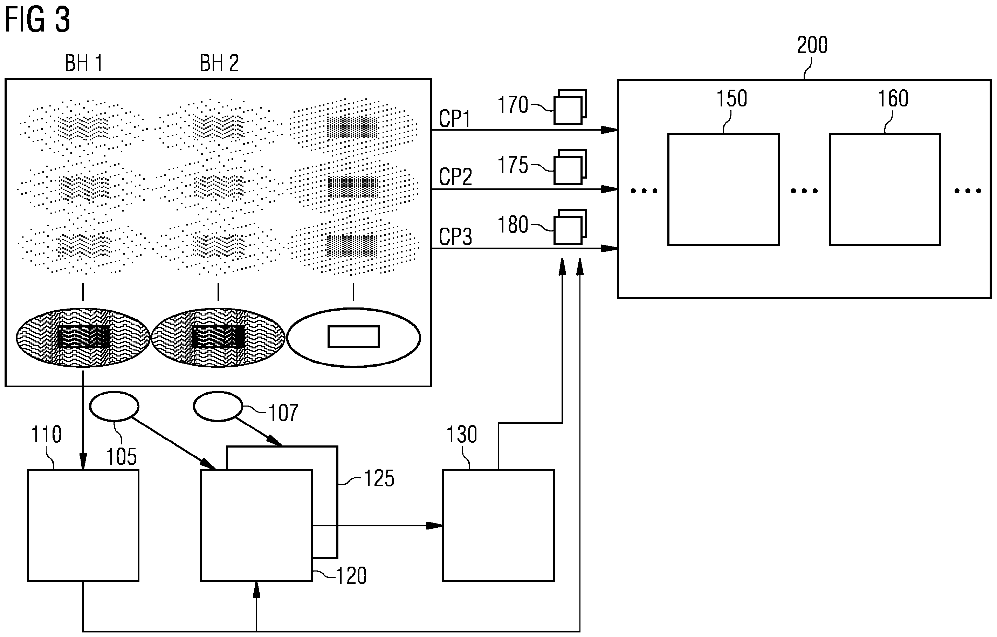

Based on the datasets acquired at the first breath hold, a summation dataset 55 can be generated which combines the data sets 30, 40 and 50 and all the following datasets acquired in the same breath hold. This dataset 55 has a central part 57 and a peripheral part 56. The central part 57 is preferably a fully sampled k space part and can be used to reconstruct coil sensitivity maps as discussed later in connection with Fig. 3. In the same way a second summation MR dataset 85 can be generated from the datasets acquired at the second breath hold. Only some of the datasets, but not all of them obtained at the BH1 could be used and combined to a combined dataset 105 (shown in Fig. 3) to reconstruct a three-dimensional image 120 representing the exact respiratory position at each of the breath holds in a 3D. This image can be seen as a single phase projection of the data contained in the breath hold and should ideally contain as little as possible cardiac motion to avoid blurring. In the same way, a second breath hold image 125 is determined from some of the second MR datasets, the combined dataset 107 acquired at the second BH. In an alternative all datasets at the first BH or all datasets at the second BH could be used for the images 120, 125, respectively. After having obtained said 3D breath hold images from a non-rigid registration of these motion states, 3 D motion fields can be generated. When N breath hold image acquisitions take place, with N being an integer larger or equal to 2, this yields 1, 2,... N-1 explicit 3D motion fields with the reference motion state being the first breath hold or any of the other breath holds.

Furthermore, it is possible to combine the data sets acquired at the different breath holds but at the same cardiac phase resulting in image dataset 90 which is the combination of data set 30 and 60. In view of the k-space densities of datasets 30 and 60 the data set 90 has a central part 92 having a higher k-space density than the peripheral part 91. The summation of the datasets of the same cardiac phase lead to the phase specific datasets 90, 95 and 96 wherein the summation, the different breath holds and cardiac phases leads to the k-space dataset 97 having a central part 99 and a peripheral part 98. This dataset 97 could be used for the creation of another morphological 3D dataset, and when the number of cardiac phases is small enough little cardiac motion is present in this dataset.

In the following reference is also made to Fig. 3 where the generation of the final image, such as CINE images, is explained in more detail. The left upper part shown in Fig. 3 corresponds to the datasets explained above in connection with Fig. 2 for the different breath holds and cardiac phases. The k-space central part 57 of dataset 55 is a fully-sampled k-space part meaning that the Nyquist theorem in this part is met. This central part 57 can then be used to reconstruct coil sensitivity maps as symbolized by map 110 shown in Fig. 3. Furthermore, it is possible to reconstruct the breath hold images from some of the variable number of phases, the combined datasets 105, 107 which gives as a result one 3D image per breath hold which in the present example gives a 3D image 120 for the first breath hold and a second 3D image 125 for the second breath hold. These two images 120 and 125, which are three-dimensional datasets, can be used to find the motion information 130 between the two breath holds. In the example shown with two breath holds it is a single motion field which identifies the motion occurring between the two breath holds which mainly indicates the position of the heart in view of a different breath hold position by the patient. It has been observed that even with the same breath hold command the positions of the heart inside the body varies considerably. The motion information or motion field, a 3D motion field, can be a three-dimensional non-rigid transformation of features and their location at the first breath hold and the second breath hold. The coil sensitivity map 110 is used for the reconstruction of the breath hold images 120 and 125. For each of the cardiac phases CP1, CP2, etc. each phase is reconstructed separately using the data from all breath holds. This reconstruction can use a temporal regularization between phases making use of temporary varying sampling patterns such as CAIPIRINHA. The combination and summation of the individual breath hold data sets using the motion information 130 and the coil sensitivity maps 110 can be implemented inside an algorithm such as SENSE or inside the temporal regularization function. The results are final datasets 170, 175, 180, which can be used to generate final MR image data 200 including for different slice positions of the heart the MR image sets 150 and 160, which show, for each of the slice positions the beating movement of the heart. The image sets 150 and 160 can be played as a loop for slices in the 3D volume so that for certain slice a time resolved image or movie can be generated wherein the same is true for another slice position of the heart such as image set 160. Preferably the resolution in all k-space directions is the same so that any slice orientation or position can be selected for the final image data. The reconstruction of the MR images sets 150, 160 can happen in multiple ways based on some of the MR datasets 30 to 99 and the motion information even without an explicit generation of the final datasets 170, 175, and 180.

The final, temporally regularized reconstruction using e.g. compressed sensing gives a dynamic 3D and time series such as the image sets 150 and 160 which then takes into account the motion information 130, by way of example in each SENSE iteration step by
A) performing the SENSE reconstruction iteration across all cardiac phases for all breath holds,
B) applying a motion field warp to each phase from each breath hold apart from the reference breath hold,
C) sum the now co-registered phases across breath holds, effectively collapsing the breath hold dimension,
D) performing a temporal regularization across the cardiac phases dimension,
E) performing the next iteration of the reconstruction algorithm.

In order to facilitate the above, the data acquisition may be structured such that first of all the reconstruction of a single 3D image for each breath hold representing the respiratory motion state with minimal cardiac motion is supported. Accordingly, image 120 should have minimal cardiac motion. Secondly, a compressed sensing reconstruction across phases can be used which requires a high degree of sample variation in each phase after the summation across the breath holds, which corresponds to a high degree of sampling variation between combined phases designated as 91, 95, 96 in Fig. 2. Thirdly coil sensitivity maps, the map 110 can be calculated from the fully sampled central region of k-space, here from k-space central part 57.

As a consequence, it is not necessary to acquire the coil sensitivity map in a separate scan. This scan would need to be at the same motion state as the data to be reconstructed using the motion state. This would mean adding the reference scan to the existing breath hold which would reduce the valuable window for the actual data acquisition. Accordingly, the sampling pattern as shown in Fig 2 or 3 is such that fully sampled regions of k space naturally occur, here the center 57, in the generated datasets as discussed above. By using the central k-space part of the k-space added for the same breath hold, this problem is solved without an extra data acquisition. In the situation shown in Fig. 2 and 3 the following sampling scheme can be used, wherein sampling in the phase encoding, PE, and partition encoding direction, PA, is used. The sampling mask in the PE x PA plane for each cardiac phase can be split between the outer region, the peripheral part and the central wherein the outer region may have an acceleration of 4x5 or 5x5 in the elliptical part, wherein the rectangular central part which can include 30 to 40% of the field of view depending on the scan resolution, can be accelerated with a factor of 2x2. The sampling positions (between the datasets 30 and 40 or between datasets 30 and 60) can be varied in a Caipirinha-like fashion between the different cardiac phases so that the sum of all samples across all phases would lead to a fully sampled outer region when a number of cardiac phases to the total acceleration factor would be prescribed, by way of example 20 phases for acceleration 4x5. Furthermore, the sampling mask for each cardiac phase can be split across the number of breath holds in such a way that
I) All phases in all breath holds are assigned the same number of k-space samples,
II) the sum of k-space samples across all phases in each individual breath hold results in a fully sampled inner region meaning that the central parts of data sets 30-50 result in a fully sampled k-space central part 57.
III) potential repetitions in the central regions (32, 42, 52) are structured such that a fully sampled inner k-space can be achieved by summation across the smallest possible number of adjacent phase masks.

The smallest possible number corresponds to the inner acceleration times the number of breath holds. By way of example for an acquisition with 4x5 acceleration in the peripheral part and 2x2 acceleration in the central part over two breath holds, the summation of the latter 8 of 20 phases yields a data set with a fully sampled inner k-space and an outer acceleration of 2.5 that can be reconstructed to a single 3D volume containing limited cardiac motion which represents the respiratory motion state of the respective breath hold. These 8 3D MR image datasets can define the subset to generate the datasets 105, 107 which are used to generate the breath hold images 120, 125. The subset can be determined based on the number of total breath holds and the acceleration factor used in the central part of k space. In general the subset or the datasets from the first 3D MR datasets to be included in the subset can be combined in such a way that he cardiac motion in the different breath hold images is minimized. This could be based on another external physiological signal such as an ECG trace or population-based statistics on average motion during the RR interval.

A non-rigid registration of all additional 3D single phase datasets with respect to the first breath hold yields the motion fields between the breath hold positions. In a time efficient implementation, the calculation of the coil sensitivity map 110 could start directly after the acquisition of the first breath hold images during acquisition of the following ones.

The full dynamic 3D datasets 200 can be calculated using a temporarily regularized compressed sensing reconstruction with integrated motion compensation as mentioned above. As the different datasets are acquired at different cardiac phases it should be understood that an ECG gating is carried out during data acquisition.

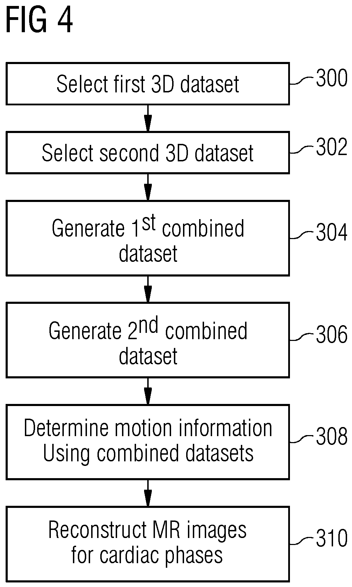

Fig. 4 summarizes some of the steps which help to obtain the MR images, especially three-dimensional MR images over time. In a step 300 first 3D MR datasets are selected which were acquired at a first breath hold over several cardiac phases. Referring to Fig. 2 and 3 this means that the data set 30, 40 and 50 as acquired by the MR system can be selected. In step 302 second datasets are selected which were acquired at a second breath hold, in the example shown in Fig. 2 and 3 of the datasets 60, 70 or 80. In step 304 a first combined dataset is generated based on some of the datasets of the first breath hold. In the same way a combined dataset is generated for the second breath hold based on some of the datasets obtained at the second breath hold (step 306). Based on the combined datasets it is possible to determine a motion information 130 (step 308). Based on the motion information and the first and second datasets it is possible to determine and reconstruct the MR images in step 310 which can be optionally viewed in a movielike structure for different slice positions of the heart.

When different breath holds are used a small difference in breath hold positions occur despite identical breathing commands which would lead to a significant blurring if the data were combined without correction. Free-running acquisitions as known in the art acquire a large amount of data over a long period of time and rely on retrospective separation of both cardiac and respiratory motion using a heavily regularized reconstruction to handle the undersampling that is connected with binning data across both degrees of freedom. While the separation of data into cardiac phases and a regularized compressed sensing reconstruction can occur in the approach of the prior art and in the approach discussed in the present application, the proposed solution discussed above uses ECG gating to structure the sampling in a more targeted way. Furthermore, the breath holds in combination with the respiratory correction efficiently eliminate the respiratory data dimension thereby reducing the amount of data to be acquired and reconstructed by a large factor leading to a fast acquisition and an easier and technically feasible reconstruction.

## Claims

1. A method for generating MR images of a heart of a patient, the method comprising at a processing unit (100):
- selecting first 3D MR datasets (30, 40, 50) acquired at a first breath hold of the patient over a plurality of cardiac phases,
- selecting second 3D MR datasets (60, 70, 80) acquired at a second breath hold of the patient over several cardiac phases,
- generating a first combined MR dataset (105) based on at least some of the first 3D MR datasets at the first breath hold,
- generating a second combined MR dataset (107) based on at least some of the second 3D MR datasets at the second breath hold,
- determining a motion information (130) for the heart between the first and second breath hold based on the first and second combined MR dataset,
- reconstructing, for each of the plurality of cardiac phases, MR images of the heart based on the first 3D MR datasets, the motion information and the second 3D MR datasets.

2. The method of claim 1, wherein the first and second 3D MR datasets are k-space datasets and each of the first and second 3D MR datasets comprises a central part and a peripheral part, wherein the central part comprises a higher k-space density than the peripheral part.

3. The method of claim 2, wherein the first and second 3D MR datasets were acquired with several receiving coils, wherein a 3 D coil sensitivity map is determined from a central part of the first combined MR dataset, and the 3D coil sensitivity map is used for determining the final 3D MR datasets.

4. The method of any preceding claim, wherein the 3D MR datasets are k-space datasets and the first and the second 3D MR datasets are configured such that they have substantially no k-space data point in common.

5. The method of any preceding claim, further comprising:
- determining a motion compensated second 3D MR dataset for each of the cardiac phases based on the motion information and the second 3D MR dataset,
wherein reconstructing the MR images comprises combining the first 3D MR dataset of a first cardiac phase with the motion compensated second 3D MR dataset of the first cardiac phase, and combining the first 3D MR dataset of a second cardiac phase with the motion compensated second 3D MR dataset of the second cardiac phase, wherein MR images are cardiac phase specific MR images.

6. The method of any of claims 3 to 5, wherein determining the motion information comprises:
- determining a first breath hold image based on a subset of the first 3D MR datasets and the 3D coil sensitivity map,
- determining a second breath hold image based on a subset of the second 3D MR datasets and the 3D coil sensitivity map,
- determining the motion information based on a comparison of the first breath hold image to the second breath hold image.

7. The method of claim 6 wherein the subset of the first and second 3D MR image datasets is determined based on a number of breath hold acquisitions and an acceleration factor used in a central part of the corresponding 3D MR image datasets.

8. The method of claim 6, wherein the subset of the first and second 3D MR image datasets is determined such that a cardiac motion in the first and second breath hold images is minimized.

9. The method of claim 6 to 8, wherein a number of first 3D MR datasets contained in the subset is a minimum number of datasets from the first 3D MR datasets obtained based on an acceleration factor used in a central part of each of the first 3D MR datasets times a number of breath holds, wherein this minimum number of datasets, when combined, provides a fully sampled central part in k space.

10. The method of any preceding claim, wherein the selected first 3D MR datasets and the selected second 3D MR datasets were acquired such that the first and second 3D MR datasets have the same amount of k space data points.

11. The method of any of claims 2 to 10, wherein the first 3D MR Data sets were acquired such that the central part of the first combined 3D dataset is a fully sampled k-space, and the second 3D MR Data sets were acquired such that the central part of the second combined 3D dataset is a fully sampled k-space.

12. The method of any preceding claim, wherein the MR images are generated using a compressed sensing technique.

13. The method of any of claims 2 to 12, wherein the first 3D MR dataset acquired at a first cardiac phase and the second 3D MR dataset acquired at the same first cardiac phase are combined to a phase specific MR dataset, wherein the central part of the phase specific MR dataset is fully sampled in k-space.

14. The method of any of claims 2 to 13, wherein the peripheral part, in a direction perpendicular to a read out direction comprises an elliptical outer shape and the central part has a rectangular shape.

15. The method of any preceding claim, wherein N 3D MR datasets are selected at N breath holds, wherein the motion information is determined N-1 times.

16. MR imaging system comprising a processing unit (100) configured to generate MR images of a heart of a patient, the processing unit being configured to
- select first 3D MR datasets acquired at a first breath hold of the patient over a plurality of cardiac phases,
- select second 3D MR datasets acquired at a second breath hold of the patient over several cardiac phases,
- generate a first combined MR dataset based on at least some of the first 3D MR datasets at the first breath hold,
- generate a second combined MR dataset based on at least some of the second 3D MR datasets at the second breath hold,
- determine a motion information for the heart between the first and second breath hold based on the first and second combined MR dataset,
- reconstruct, for each of the plurality of cardiac phases, MR images of the heart based on the first 3D MR datasets, the motion information and the second 3D MR dataset.

17. A computer program comprising program code, that when executed by the processing unit, causes the processing unit to perform a method as mentioned in any of claims 1 to 15.
